Europäisches Patentamt

European Patent Office

Office européen des brevets

(11) Veröffentlichungsnummer: **0 241 829**
**A2**

## (12) EUROPÄISCHE PATENTANMELDUNG

(21) Anmeldenummer: 87105013.4

(51) Int. Cl.⁴: **H03K 17/74**

(22) Anmeldetag: 04.04.87

(30) Priorität: 16.04.86 DE 3612732

(43) Veröffentlichungstag der Anmeldung:
**21.10.87 Patentblatt 87/43**

(84) Benannte Vertragsstaaten:
**DE FR GB IT**

(71) Anmelder: **Blaupunkt-Werke GmbH**
**Robert-Bosch-Strasse 200**
**D-3200 Hildesheim(DE)**

(72) Erfinder: **Gerendt, Siegfried**
**Hammersteinstrasse 118**
**D-3200 Hildesheim(DE)**

(74) Vertreter: **Eilers, Norbert, Dipl.-Phys.**
**Blaupunkt-Werke GmbH**
**Robert-Bosch-Strasse 200**
**D-3200 Hildesheim(DE)**

(54) **Anordnung zum Schalten von hochfrequenten Signalen.**

(57) Bei einer Anordnung zum Schalten von hochfrequenten Signalen ist im Weg der Signale ein T-Glied angeordnet, dessen Längszweige von Dioden gebildet sind und dessen Querzweig aus einem Kondensator besteht. In einem UKW-Empfangsgerät, bei welchem zwei Zwischenfrequenz-Signalwege verschiedener Bandbreite parallelgeschaltet sind, ist je eine derartige Anordnung in die Zwischenfrequenz-Signalwege geschaltet.

Fig. 1

EP 0 241 829 A2

## Anordnung zum Schalten von hochfrequenten Signalen

Die Erfindung geht aus von einer Anordnung nach der Gattung des Hauptanspruchs.

Zum Schalten von hochfrequenten Signalen sind verschiedene Anordnungen bekannt geworden. Häufig wird eine Diode im Signalweg angeordnet, welche durch Anlegen entsprechender Schaltspannungen in den leitenden oder nichtleitenden Zustand gebracht werden kann. Durch die Sperrkapazität der Diode ist jedoch die Dämpfung im gesperrten Zustand für höhere Frequenzen für verschiedene Anwendungen nicht hoch genug. Versuche, mehrere Dioden in Reihe zu schalten, haben ebenfalls nicht einen besonders hohen Wert für die Sperrdämpfung ergeben.

Ein besonders hoher Wert für die Sperrdämpfung wird in UKW-Empfangsgeräten mit umschaltbarer Selektion gefordert, bei welchen das Zwischenfrequenzsignal über zwei Wege vom Empfangsteil zum Zwischenfrequenzverstärker geleitet wird. Dabei ist in einem der Wege ein zusätzliches Filter vorgesehen. Mit in beiden Wegen angeordneten Hochfrequenzschaltern werden die Zwischenfrequenzsignale über jeweils einen der Wege geleitet. Für diese Schalter ist eine hohe Sperrdämpfung zu fordern, da anderenfalls beim Betrieb des UKW-Empfangsgerätes mit hoher Selektion, also mit geringer Bandbreite, durch den Signalweg mit hoher Bandbreite Signalanteile außerhalb des schmalen Durchlaßbereichs zum Zwischenfrequenzverstärker gelangen und somit die Selektionseigenschaften verschlechtert werden.

Die erfindungsgemäße Anordnung mit den kennzeichnenden Merkmalen des Hautanspruchs hat demgegenüber den Vorteil, daß mit einfachen - schaltungstechnischen Mitteln eine sehr hohe Sperrdämpfung gewährleistet ist.

Durch die in den Unterranspruchen aufgeführten Maßnahmen sind vorteilhafte Weiterbildungen und Verbesserungen sowie eine vorteilhafte Anwendung der im Hauptanspruch angegebenen Erfindung möglich. Dabei erfüllt eine erfindungsgemäße Anordnung mit zwei Dioden die meisten Anforderungen. Die Erfindung schließt jedoch die Anwendung mehrerer Dioden je Längszweig oder die Ergänzung des T-Gliedes durch ein oder mehrere weitere Glieder aus Längsdioden und Querkapazitäten nicht aus.

Ausführungsbeispiele der Erfindung sind in der Zeichnung an Hand mehrerer Figuren dargestellt und in der nachfolgenden Beschreibung näher erläutert. Es zeigt:

Fig. 1 ein Schaltbild einer erfindungsgemäßen Anordnung und

Fig. 2 ein Blockschaltbild einer Schaltungsanordnung in einem UKW-Empfangsgerät, welche zwei Anordnungen gemäß Fig. 1 umfaßt.

Gleiche Teile sind in den Figuren mit gleichen Bezugszeichen versehen.

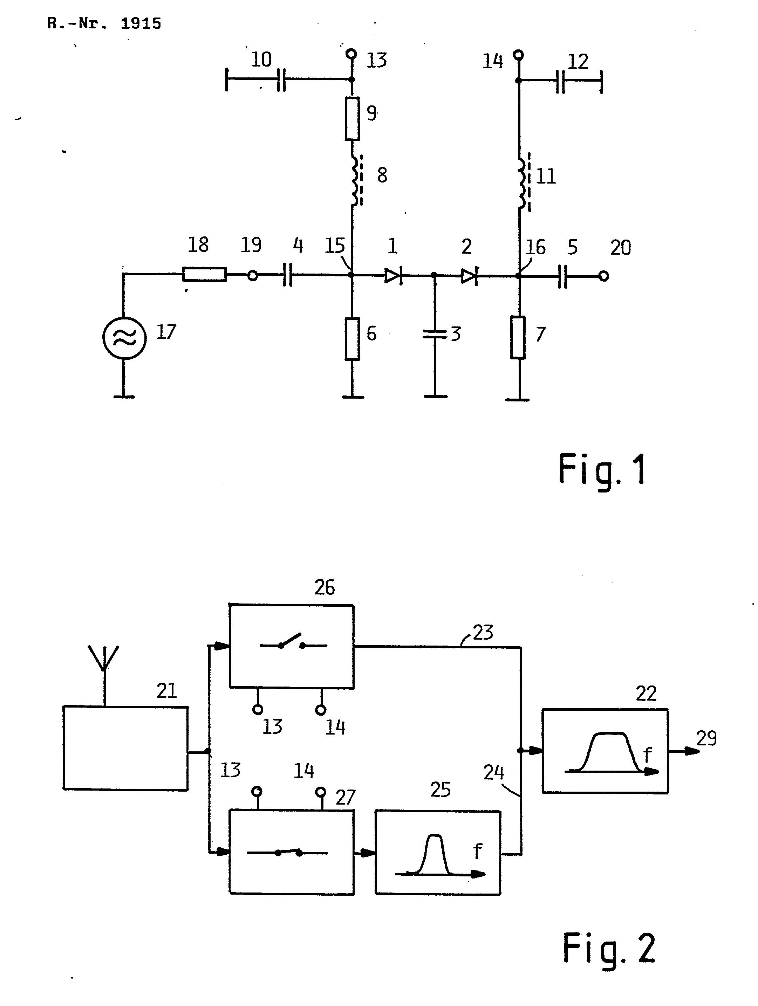

Bei der Anordnung nach Fig. 1 bilden die Dioden 1 und 2 sowie der Kondensator 3 ein T-Glied, welches im Weg der zu schaltenden Signale angeordnet ist. Soll die Anordnung leitend sein, so wird bei 13 eine positive Schaltspannung angelegt, welche einen Strom über den Widerstand 9, die Induktivität 8, die beiden Dioden 1 und 2 sowie über den Widerstand 7 zur Folge hat. Dabei ist die Größe der Widerstände 7 und 9 derart gewählt, daß ein ausreichender Strom fließt, um die Dioden 1 und 2 genügend niederohmig zu machen.

Zur Sperrung der Anordnung nach Fig. 1 wird bei 14 eine positive Schaltspannung angelegt, während bei 13 keine Spannung anliegt. Der Eingang 15 des T-Gliedes wird somit über den Widerstand 6 auf Massepotential gelegt. Die Dioden 1 und 2 erhalten eine Sperrspannung, so daß sie für das hochfrequente Signal nichtleitend werden. Dabei bildet der Kondensator 3 mit der Sperrkapazität der Diode 1 einen Spannungsteiler. Die Kapazität des Kondensators 3 ist wesentlich größer als die Sperrkapazität der Diode 1 gewählt, so daß eine hohe Dämpfung für die durch die Sperrkapazität hindurchgelassenen Signale entsteht. Bei leitenden Dioden 1, 2 ist jedoch der kapazitive Leitwert des Kondensators 3 für die in Fage kommenden Frequenzen klein gegenüber dem Leitwert der Dioden 1, 2 und des Widerstandes 7, so daß eine unzulässige Dämpfung der zu schaltenden Signale im oberen Frequenzbereich nicht erfolgt.

Die Induktivitäten 8 und 11 bilden zusammen mit dem Widerstand 9 und dem Kondensator 10 bzw. zusammen mit dem Kondensator 11 Tiefpässe, die verhindern, daß hochfrequente Signale auf die nicht dargestellten Leitungen für die Schaltspannungen gelangen und somit Störungen hervorrufen.

Zur weiteren Erläuterung ist in Fig. 1 eine Signalquelle 17 und ein Anpassungswiderstand 18 dargestellt, welcher zwischen der Signalquelle 17 und dem Eingang 19 der als Schalter dienenden Anordnung eingefügt ist. Am Ausgang 20 ist die geschaltete Hochfrequenzspannung abnehmbar. Zwischen dem Eingang 19 und dem Schaltungspunkt 15 sowie zwischen dem Schaltungspunkt 16 und dem Ausgang 20 ist je ein Koppelkondensator 4, 5 vorgesehen, welche die Schaltspannungen vom zu schaltenden Signal trennen.

Bei der in Fig. 2 dargestellten Schaltungsanordnung sind zwischen einem UKW-Eingangsteil 21 und einem selektiven Zwischenfrequenzverstärker 22 zwei parallele Signalwege 23, 24 angeordnet. An den Ausgang 29 des Zwischenfrequenzverstärkers sind in an sich bekannter Weise weitere Stufen des UKW-Empfangsgerätes angeschlossen.

Während die Hauptselektion im Zwischenfrequenzverstärker 22 erfolgt, sind im Signalweg 24 zusätzliche Selektionsmittel (Bandfilter) 25 angeordnet. Mit den Schaltern 26 und 27 kann jeweils einer der Signalwege 23, 24 ein-sowie der andere ausgeschaltet werden. Dazu werden den Schalteingängen 13, 14 der Schalter 26, 27 entsprechende Schaltspannungen zugeführt. Durch die hohe Sperrdämpfung der erfindungsgemäßen Anordnung wird erreicht, daß beim Betrieb der Schaltungsanordnung nach Fig. 2 mit der zusätzlichen Selektion, wobei der Schalter 26 gesperrt und der Schalter 27 leitend ist, keine unzulässig hohen breitbandigen Restsignale durch den Schalter 6 hindurchgelassen werden und somit die Selektionseigenschaften verschlechtern.

Bei einer praktisch ausgeführten erfindungsgemäßen Anordnung wurde für die Größe des Kondensators C = 18pF gewählt, während Dioden vom Typ BA 281 benutzt wurden. Die damit erzielte Sperrdämpfung erreichte einen typischen Wert von 58 dB.

## Ansprüche

1. Anordnung zum Schalten von hochfrequenten Signalen, dadurch gekennzeichnet, daß im Weg der Signale ein T-Glied angeordnet ist, dessen Längszweige von Dioden (1, 2) gebildet sind und dessen Querzweig aus einem Kondensator (3) besteht.

2. Anordnung nach Anspruch 1, dadurch gekennzeichnet, daß die Längszweige aus je einer Diode (1, 2) gebildet sind.

3. Anordnung nach Anspruch 2, dadurch gekennzeichnet, daß die Dioden (1, 2) in gleicher Richtung gepolt sind.

4. Anordnung nach Anspruch 3, dadurch gekennzeichnet, daß die vom Kondensator (3) abgewandten Elektroden der Dioden (1, 2) mit je einem Koppelkondensator (4, 5), über je einen Widerstand (6, 7) mit festem Potential und über je einen Tiefpaß (8, 9, 10, 11, 12) mit je einer Quelle (13, 14) für eine Schaltspannung verbunden sind.

5. Anordnung nach Anspruch 4, dadurch gekennzeichnet, daß die Tiefpässe (8, 9, 10; 11, 12) je eine Induktivität (8, 11) umfassen.

6. Anordnung nach Anspruch 4, dadurch gekennzeichnet, daß die Anode derjenigen Diode (1), deren Kathode mit dem Kondensator verbunden ist, den Eingang (15) des T-Gliedes bildet.

7. Schaltungsanordnung in einem UKW-Empfangsgerät, bei welchem zwei Zwischenfrequenz-Signalwege (23, 24) verschiedener Bandbreite parallelgeschaltet sind, dadurch gekennzeichnet, daß je eine Anordnung (26, 27) nach einem der Ansprüche 1 bis 6 in die Zwischenfrequenz-Signalwege (23, 24) geschaltet ist.

R.-Nr. 1915

Fig. 1

Fig. 2